# EUROPÄISCHE PATENTANMELDUNG

(11) **EP 3 940 523 A1**
(43) Veröffentlichungstag der Anmeldung: **19.01.2022**
(21) Anmeldenummer: 21185776.8
(22) Anmeldetag: 15.07.2021
(51) Int. Cl.: G06F 3/06, G06F 12/02, G01D 4/00, G01R 19/25, G01R 22/00

(54) **VERFAHREN ZUM SPEICHERN VON PQ-DATEN IN EINEM FLASH-SPEICHER UND ELEKTRIZITÄTSZÄHLER ZUR AUSFÜHRUNG DES VERFAHRENS**

(30) Priorität: 15.07.2020 DE 102020118648
(71) Anmelder: EMH metering GmbH & Co. KG, 19258 Gallin (DE)
(72) Erfinder: Lübeck, Felix, 21614 Buxtehude (DE)
(74) Vertreter: Hauck Patentanwaltspartnerschaft mbB

(57) **Zusammenfassung**

Verfahren zum Speichern von PQ-Daten in einem Flash-Speicher, mit den folgenden Schritten:
• Bereitstellen eines Flash-Speichers,
• Periodisches Erfassen von PQ-Daten mit einer Anzahl N von Kanälen, wobei in zeitlich aufeinanderfolgenden Perioden für jeden der N Kanäle ein Messwert anfällt,
• Periodisches Speichern der Daten in dem Flash-Speicher, und
• Organisieren des Flash-Speichers in eine Anzahl N von Speicherbereichen für den ersten bis N-ten Kanal, wobei jeder der Speicherbereiche eine Startadresse und ein fortlaufendes, an der Startadresse beginnendes Speichervolumen aufweist, wobei
• beim periodischen Speichern der Daten in einer ersten Periode für jeden Kanal ein erster Messwert an einer ersten Position des zugehörigen Speicherbereichs gespeichert wird und in jeder weiteren Periode für jeden Kanal ein weiterer Messwert in dem zugehörigen Speicherbereich gespeichert wird, und zwar an einer sich an den in der vorherigen Periode in diesem Speicherbereich gespeicherten Messwert anschließenden Position.

## Beschreibung

Die Erfindung betrifft ein Verfahren zum Speichern von PQ-Daten in einem Flash-Speicher sowie einen Elektrizitätszähler zur Ausführung des Verfahrens. PQ (*power quality*)-Daten sind Daten zur Qualität eines elektrischen Versorgungsnetzes, sie beschreiben also die Spannungs- bzw. Netzqualität.

Für eine aussagekräftige Überwachung der Netzqualität können zum Beispiel spezielle Elektrizitätszähler eingesetzt werden, die eine Vielzahl von Daten erheben. Hierzu kann der Elektrizitätszähler kontinuierlich Spannung und Strom jeder Phase des betrachteten Versorgungsnetzes messen. Ausgehend von diesen Messungen können beispielsweise Frequenzspektren der einzelnen Größen ermittelt werden. Zur Bewertung der Netzqualität ist zum Beispiel eine Analyse einer Vielzahl von Harmonischen und Subharmonischen der Netzfrequenz üblich. Es entstehen daher schnell sehr umfangreiche Datensätze.

Die Speicherung der PQ-Daten kann in einem Flash-Speicher erfolgen. Flash-Speicher werden in den letzten Jahren im Zusammenhang mit Elektrizitätszählern vermehrt eingesetzt, weil sie in geeigneten Größen relativ kostengünstig verfügbar sind und eine hohe Datensicherheit bieten. Insbesondere bleiben die gespeicherten Daten auch bei dem Ausfall einer Versorgungsspannung erhalten.

Beim Speichern von Daten in einem Flash-Speicher ist es grundsätzlich wünschenswert, die Anzahl der Schreibvorgänge möglichst gering zu halten. Dies liegt einerseits daran, dass Flash-Speicher in der Regel nur eine begrenzte Anzahl von Schreib- bzw. Löschvorgängen zulassen. Zum anderen ist ein kontinuierliches Speichern einer bestimmten Datenmenge bei einem Flash-Speicher wesentlich schneller möglich, als ein Speichern derselben Datenmenge in kleineren Datenpaketen.

Andererseits ist es beim Auslesen grundsätzlich wünschenswert, die Anzahl der Lesevorgänge möglichst gering zu halten. Denn ein kontinuierliches Lesen einer bestimmten Datenmenge ist bei einem Flash-Speicher wesentlich schneller möglich, als ein Lesen derselben Datenmenge in kleineren Datenpaketen. Um sowohl beim Schreiben, als auch beim Lesen die Anzahl der Vorgänge möglichst gering zu halten, wurden die Daten deshalb in der Vergangenheit genau in der Abfolge geschrieben, wie sie später auch wieder ausgelesen wurden. Auf diese Weise wurde beispielsweise alle 10 Minuten jeweils ein Datensatz in chronologischer Abfolge gespeichert. Dabei war es einfach möglich, einen Ringspeicher zu organisieren, in dem jeweils der Block mit den ältesten Datensätzen bei Bedarf gelöscht werden konnte.

Aus der Druckschrift EP 1 792 288 B1 ist ein Elektrizitätszähler mit einem Flash-Speicher bekannt geworden, der den erläuterten Besonderheiten von Flash-Speichern dadurch Rechnung trägt, dass die Messdaten in einem Arbeitsspeicher gepuffert und erst dann in den Flash-Speicher geschrieben werden, wenn der Puffer voll ist. Ein ähnliches Verfahren ist aus der Druckschrift WO 01/01157 A1 bekannt. Ein wesentlicher Nachteil dieses Ansatzes bestand darin, dass bereits beim Schreiben feststehen musste, welche Daten später ausgelesen werden sollten. Es war also vorab auszuwählen, welche Teilmenge der verfügbaren Daten in den Flash-Speicher geschrieben werden sollte.

Davon ausgehend ist es ist die Aufgabe der Erfindung, ein Verfahren zum Speichern von PQ-Daten in einem Flash-Speicher zur Verfügung zu stellen, das die Weiterverarbeitung und Auswertung der Daten vereinfacht, sowie einen Elektrizitätszähler zur Ausführung des Verfahrens.

Diese Aufgabe wird gelöst durch das Verfahren mit den Merkmalen des Anspruchs 1. Vorteilhafte Ausgestaltungen sind in den sich anschließenden Unteransprüchen angegeben.

Das Verfahren dient zum Speichern von PQ-Daten in einem Flash-Speicher und weist die folgenden Schritte auf:
- Bereitstellen eines Flash-Speichers,
- periodisches Erfassen von PQ-Daten mit einer Anzahl N von Kanälen, wobei in zeitlich aufeinanderfolgenden Perioden für jeden der N Kanäle ein Messwert anfällt, und
- periodisches Speichern der Daten in dem Flash-Speicher.

Weiterhin weist das Verfahren den folgenden Schritt auf:
- Organisieren des Flash-Speichers in eine Anzahl N von Speicherbereichen für den ersten bis N-ten Kanal, wobei jeder der Speicherbereiche eine Startadresse und ein fortlaufendes, an der Startadresse beginnendes Speichervolumen aufweist, wobei
- beim periodischen Speichern der Daten in einer ersten Periode für jeden Kanal ein erster Messwert an einer ersten Position des zugehörigen Speicherbereichs gespeichert wird und in jeder weiteren Periode für jeden Kanal ein weiterer Messwert in dem zugehörigen Speicherbereich gespeichert wird, und zwar an einer sich an den in der vorherigen Periode in diesem Speicherbereich gespeicherten Messwert anschließenden Position.

Bei dem Verfahren werden die PQ-Daten, also Daten, die die Qualität eines elektrischen Versorgungsnetzes beschreiben, periodisch erfasst und gespeichert. Die zeitlich aufeinanderfolgenden Perioden können beispielsweise eine Dauer von 10 oder 15 Minuten aufweisen, aber auch eine davon deutlich abweichende, längere oder kürzere Dauer. In jeder Periode wird die Netzqualität überwacht, wobei eine Vielzahl von Messdaten unmittelbar gemessen bzw. aus den gemessenen Daten ermittelt oder berechnet werden, insbesondere für jede Phase des Versorgungsnetzes eine Vielzahl von Harmonischen und Subharmonischen von Spannung und Strom. Die Erfindung ist jedoch nicht auf diese spezielle Beschreibung der Netzqualität anhand der genannten Größen beschränkt, sondern kann grundsätzlich für sämtliche PQ-Daten eingesetzt werden, die periodisch mit einer Vielzahl von Kanälen erfasst werden.

Im Unterschied zu den aus dem Stand der Technik bekannten Verfahren, bei denen die anfallenden Daten als zusammenhängendes Datenpaket in den Flash-Speicher geschrieben werden, wird bei der Erfindung der Flash-Speicher in eine Anzahl N von Speicherbereichen für den ersten bis N-ten Kanal aufgeteilt. Jeder Speicherbereich weist eine Startadresse und ein fortlaufendes, an der Startadresse beginnendes Speichervolumen auf. Somit ist jeder Speicherbereich zur Speicherung der einem bestimmten der N Kanäle zugeordneten Messwerte vorgesehen, beispielsweise könnte es einen Kanal für die erste Harmonische der Spannung der Netzfrequenz und einen weiteren Kanal für die zweite Harmonische der Spannung der Netzfrequenz geben.

Beim periodischen Speichern der Daten werden dann nicht etwa einzelne der N-Speicherbereiche in einer Periode gefüllt, sondern es wird in jeder Periode jeder der Speicherbereiche mit (genau) einem Messwert beschrieben. Es werden also sämtliche Speicherbereiche kontinuierlich, von Periode zu Periode, weiter mit den anfallenden Messwerten gefüllt. Dabei werden die ersten Messwerte jeweils an einer ersten Position eines Speicherbereichs gespeichert. In jeder weiteren Periode wird für jeden Kanal ein weiterer Messwert an einer weiteren Position des jeweiligen Speicherbereichs gespeichert, die sich an die Position, an der der Messwert der vorherigen Periode gespeichert wurde, anschließt. Beispielsweise kann der erste Messwert eines bestimmten Kanals an der Startadresse des zugehörigen Speicherbereichs gespeichert werden und der zweite Messwert dieses Kanals an einer unmittelbar benachbarten Position desselben Speicherbereichs. In diesem Fall werden die Speicherbereiche beginnend an der Startadresse schrittweise in zusammenhängenden Abschnitten mit Daten gefüllt. Einbezogen sind jedoch auch davon abweichende "Befüllschemata" der einzelnen Speicherbereiche. Beispielsweise kann sich die erste Position eines Speicherbereichs nicht an der Startadresse, sondern am entgegengesetzten Ende des Speicherbereichs befinden, und die Speicherbereiche können vorn dort aus schrittweise befüllt werden, sozusagen "von rechts nach links". Ebenfalls einbezogen sind kompliziertere Befüllschemata, bei denen sich die erste Position zum Beispiel an einer mittleren Position innerhalb eines Speicherbereichs befindet und die weiteren Positionen eine vordefinierte Anordnung innerhalb des Speicherbereichs aufweisen. Die sich an die vorherige Position anschließende Position muss dabei nicht unmittelbar benachbart zu der vorherigen Position angeordnet sein, sondern kann sich lediglich in einem logischen Sinn (entsprechend der vordefinierten Anordnung) an die vorherige Position anschließen.

Verglichen mit dem aus dem Stand der Technik bekannten, kontinuierlichen, paketweisen Beschreiben des Flash-Speichers mit den jeweils in einer Periode angefallenen Messdaten ist das bei der Erfindung vorgesehene, über alle Speicherbereiche verteilte Speichern der Messwerte zeitaufwendig, weil jeder Messwert einen einzelnen, entsprechend adressierten Schreibvorgang erfordert. Das Speichern sämtlicher, in einer Periode erfasster PQ-Daten kann daher unter Umständen eine relativ lange Zeit von beispielsweise mehreren Zehntelsekunden bis hin zu mehreren Sekunden in Anspruch nehmen. Dies ist jedoch in vielen Fällen akzeptabel, insbesondere in Anbetracht der üblichen Periodendauern von beispielsweise 10 Minuten. Dies gilt umso mehr, als das Speichern der PQ-Daten in dem Flash-Speicher als asynchroner Schreibvorgang im Hintergrund ausgeführt werden kann.

Ein besonderer Vorteil des Verfahrens besteht darin, dass die Daten jedes Kanals in einem zusammenhängenden Speicherbereich gespeichert werden. Sie können daher für eine weitere Verarbeitung und Auswertung besonders einfach und schnell ausgelesen werden. Dies ist in der Praxis von großer Bedeutung, weil häufig insbesondere der zeitliche Verlauf der Messwerte einzelner Kanäle über viele Perioden hinweg von Interesse ist. Die bei dem Verfahren in dem Flash-Speicher ausgebildete Datenstruktur ist daher besonders "lesefreundlich".

In einer Ausgestaltung werden die Daten jeweils einer Periode in einem Pufferspeicher gespeichert und anschließend von dem Pufferspeicher in den Flash-Speicher kopiert. Durch dieses Puffern der Daten können in hierfür vorgesehenen Speicherbereichen bereits die Messwerte einer folgenden Periode erfasst werden, bevor der Schreibvorgang in dem Flash-Speicher abgeschlossen ist.

In einer Ausgestaltung ist dieser Pufferspeicher in Form einer Queue realisiert, wobei jedes Element der Queue einen Schreibauftrag darstellt, der ein Datenfeld mit den zu schreibenden Daten aufweist sowie ein Adressfeld mit der Angabe, an welchem Ort im Flash zu speichern ist. Dadurch ist es beispielsweise möglich, ein RTOS mit mehreren Tasks einzusetzen, wobei ein Task quasi im Hintergrund die Schreibaufträge abarbeitet. Die Realisierung des Pufferspeichers in Form einer Queue hat den besonderen Vorteil, dass asynchrone Schreibaufträge aus ganz unterschiedlichen Datenquellen, d.h. insbesondere auch durch unterschiedliche Tasks veranlasst, durch einen einzigen Schreibmechanismus abgearbeitet werden können.

In einer Ausgestaltung wird das Verfahren für eine vorgegebene Anzahl P von Perioden ausgeführt, wobei die N Speicherbereiche jeweils ein Speichervolumen aufweisen, das zum Speichern von P Messwerten des zugehörigen Kanals ausreicht.

Insbesondere kann die Anzahl P von Perioden so gewählt werden, dass die Speichervolumina der Größe einer oder mehrerer Seiten (*pages*) des Flash-Speichers entsprechen. Beispielsweise können die N Speicherbereiche so dimensioniert werden, dass sie jeweils eine Anzahl *M* von Messwerten aufnehmen können. Dabei kann berücksichtigt werden, welche Größe ein einzelner Messwert beansprucht, beispielsweise 1 Byte, 2 Bytes, 3 Bytes, 4 Bytes oder allgemein eine Anzahl *m* an Bytes. Jeder der N Speicherbereiche kann also ein Volumen von (mindestens) *M* x *m* Byte aufweisen. Es versteht sich, dass Speicherbereiche unterschiedlicher Größen verwendet werden können, insbesondere wenn die in den einzelnen Kanälen erfassten Messwerte unterschiedliche Größen aufweisen.

In einer Ausgestaltung wird für jeden Kanal fortlaufend eine Kanal-Prüfsumme berechnet und in einem Arbeitsspeicher gespeichert. Die Kanal-Prüfsumme kann zur Prüfung der Integrität der Daten des jeweiligen Kanals verwendet werden. Sie wird insbesondere für jede Periode einmal für jeden Kanal berechnet bzw. aktualisiert. Das fortlaufende Aktualisieren und Speichern der Kanal-Prüfsumme in einem Arbeitsspeicher hat den Vorteil, dass die Kanal-Prüfsummen verfügbar sind, ohne dass auf sämtliche in dem jeweiligen Kanal erfassten Messwerte zugegriffen werden muss.

In einer Ausgestaltung wird nach dem Erfassen der Daten der P-ten Periode die Kanal-Prüfsumme jedes Kanals in dem Flash-Speicher gespeichert. Dies ist von Vorteil, weil anschließend die Integrität der in dem zu dem jeweiligen Kanal zugehörigen Speicherbereich des Flash-Speichers gespeicherten Daten unter Zuhilfenahme der Kanal-Prüfsumme überprüft werden kann. Kanal-Prüfsumme und Messwerte des betreffenden Speicherbereichs können dabei dem Flash-Speicher gezielt entnommen werden. Dadurch können die Daten eines bestimmten Kanals besonders einfach und fehlerfrei ausgelesen werden.

In einer Ausgestaltung weisen die N Speicherbereiche jeweils ein Speichervolumen auf, das der Größe von P Messwerten des zugehörigen Kanals zuzüglich der Größe einer Prüfsumme entspricht, wobei die Kanal-Prüfsumme jedes Kanals in dem zugehörigen Speicherbereich gespeichert wird. In diesem Fall können die Messwerte eines Kanals und die zugehörige Kanal-Prüfsumme besonders schnell und einfach einem zusammenhängenden Speicherbereich entnommen werden.

In einer Ausgestaltung wird für jede Periode eine Perioden-Prüfsumme berechnet und in dem Flash-Speicher gespeichert. Auf diese Weise kann die Integrität der in einer bestimmten Periode erfassten Daten anhand der Perioden-Prüfsumme überprüft werden.

In einer Ausgestaltung sind die Kanal-Prüfsummen und/oder die Perioden-Prüfsummen CRC-Werte. CRC steht für *cylic redudancy check,* also für eine zyklische Redundanzprüfung. Wie üblich, werden in dieser Anmeldung die CRC-Werte als Prüfsummen bezeichnet, obwohl es sich nicht im strengen Sinne um Summen einzelner Werte handelt. Die Verwendung einer zyklischen Redundanzprüfung führt zu einer verbesserten Datensicherheit.

In einer Ausgestaltung werden beim Speichern der Daten einer Periode ein erster Zeitstempel für den Beginn der Periode und ein zweiter Zeitstempel für das Ende der Periode in dem Flash-Speicher gespeichert. Anhand der beiden Zeitstempel kann jederzeit exakt nachvollzogen werden, auf welchen Zeitraum sich die betreffende Periode bezieht. Ein besonderer Vorteil besteht darin, dass auch die Daten einer unvollständigen Periode erfasst und sinnvoll ausgewertet werden können, beispielsweise im zeitlichen Zusammenhang mit einem Netzausfall.

In einer Ausgestaltung ist der Flash-Speicher in eine Anzahl von logischen Einheiten unterteilt, die dazu bestimmt sind, "am Stück" gelöscht zu werden. Diese im Folgenden als Speichersegmente bzw. Segmente bezeichneten Einheiten können jeweils einem Block entsprechen, dessen gleichzeitige Löschung vom verwendeten Flashbaustein unterstützt wird, so dass das Löschen eines Segments einer einzigen Löschoperation des Flashbausteins entspricht. Eine solche Übereinstimmung ist aber nicht notwendig und auch nicht unbedingt wünschenswert. Es kann insbesondere vorteilhaft sein, für das Löschen eines Segments sehr viele Löschoperationen jeweils eines Sektors von beispielsweise 4 KByte Größe durchzuführen an Stelle einer einzigen Löschoperation eines Blocks von beispielsweise 32 KByte Größe, weil dadurch zwar der Zeitaufwand steigen kann, aber die maximale Dauer, für die der Flashbaustein durch jeweils eine Löschoperation blockiert ist, geringer sein kann. Jedes dieser Segmente weist eine Anzahl N von Speicherbereichen für den ersten bis N-ten Kanal auf, wobei jeder der Speicherbereiche eine Startadresse und ein fortlaufendes, an der Startadresse beginnendes Speichervolumen aufweist.

In einer Ausgestaltung erfolgt das Speichern der Daten der ersten Periode in einem zuvor gelöschten Speichersegment, dessen Größe zur Aufnahme aller Daten bis zur P-ten Periode ausreicht. Es ist also eine segmentweise Löschung des Flash-Speichers vorgesehen. Zusätzliche Löschvorgänge während des Erfassens und Speicherns der Daten sind dann nicht erforderlich.

In einer Ausgestaltung werden zur Weiterverarbeitung der in dem Flash-Speicher gespeicherten Daten die Messwerte eines einzigen Kanals oder ausschließlich eines Teils der Kanäle für eine Vielzahl von Perioden ausgelesen. Insbesondere können die genannten Messwerte für alle Perioden, von der ersten Periode bis zur P-ten Periode, ausgelesen werden. Wie erwähnt, kann für das Auslesen der Messwerte jedes Kanals ein einziger Lesevorgang ausgeführt werden, der die in dem zugehörigen, zusammenhängenden Speicherbereich gespeicherten Daten in einem relativ schnell ausführbaren Vorgang ausliest.

In einer Ausgestaltung werden zur Weiterverarbeitung der in dem Flash-Speicher gespeicherten Daten die Daten ausgelesen und in Form einer PQDIF-Datei bereitgestellt. Eine PQDIF-Datei weist ein beispielsweise von der Norm IEEE Std 1159.3-2019 definiertes Format auf, das die weitere Verarbeitung der Daten vereinfachen kann, beispielsweise mithilfe einer standardisierten Software an einem Computerarbeitsplatz. Durch die bei der Erfindung vorgesehene Speicherung der einzelnen Kanäle zugehörenden Messwerte in zusammenhängenden Speicherbereichen gelingt das Erstellen einer PQDIF-Datei besonders einfach.

In einer Ausgestaltung wird das Verfahren von einem Elektrizitätszähler, der eine Messeinrichtung zum Erfassen der Daten und den Flash-Speicher aufweist, ausgeführt. Insbesondere kann es sich um einen Präzisionszähler handeln, der für eine schnelle und präzise Berechnung von Spektren aus den gemessenen Strom- und Spannungswerten der einzelnen Phasen ausführen kann.

In einer Ausgestaltung weist der Elektrizitätszähler einen Kondensator oder eine Batterie auf und im Falle eines Netzausfalls wird das Speichern bereits erfasster Daten in dem Flash-Speicher mittels Energieversorgung aus dem Kondensator bzw. aus der Batterie abgeschlossen. Ein Datenverlust bei einem Netzausfall kann dadurch vermieden werden. Auch falls eine Periode noch nicht beendet ist, kann unter Verwendung der genannten Zeitstempel eine sinnvolle Speicherung der bereits erfassten Daten vorgenommen werden.

Die oben genannte Aufgabe wird ebenfalls gelöst durch einen Elektrizitätszähler mit den Merkmalen des Anspruchs 16. Der Elektrizitätszähler weist eine Messeinrichtung zum Erfassen von PQ-Daten und einen Flash-Speicher auf sowie eine Steuerung, die dazu ausgebildet ist, ein Verfahren mit den Merkmalen eines der Ansprüche 1 bis 14 auszuführen. Diese Ausbildung der Steuerung kann insbesondere in einer geeigneten Programmierung/Software zum Ausdruck kommen. Zu den Merkmalen und Vorteilen des Elektrizitätszählers wird auf die Erläuterungen des Verfahrens verwiesen, die entsprechend gelten.

Nachfolgend wird die Erfindung anhand eines in Figuren dargestellten Ausführungsbeispiels näher erläutert. Es zeigen:
- Figur 1: einen Flash-Speicher in einer schematischen Darstellung,
- Figur 2: den Flash-Speicher aus Figur 1 nach dessen Organisation in eine Anzahl von Speicherbereichen,
- Figur 3: den Flash-Speicher aus Figur 3 nach dem Speichern der Daten der ersten Periode,
- Figur 4: den Flash-Speicher aus Figur 3 nach dem Speichern der Daten weiterer Perioden, und
- Figur 5: den Flash-Speicher aus Figur 4 nach dem Speichern der Daten der P-ten Periode.
Alle Figuren sind schematisch.

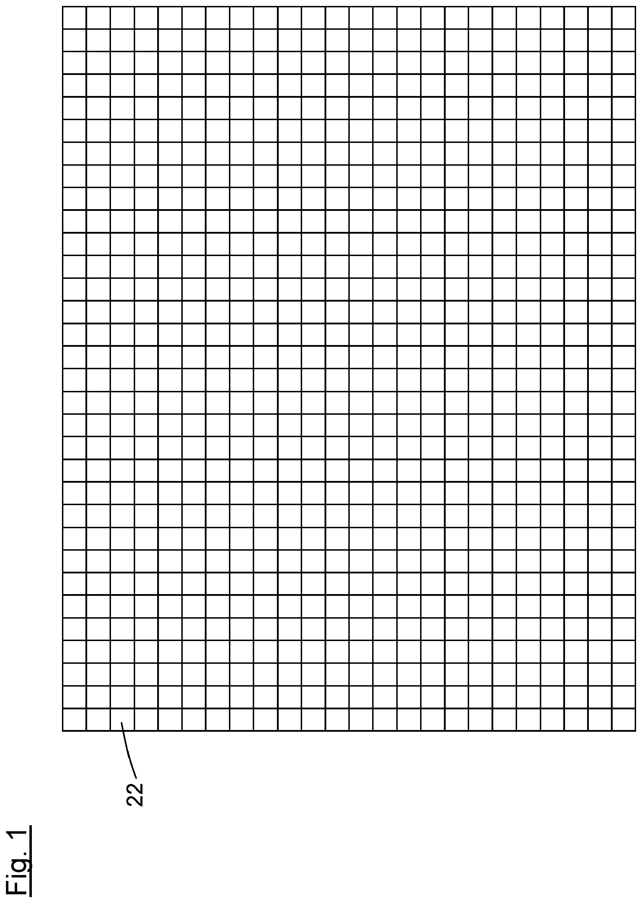

Der Flash-Speicher aus Fig. 1 ist durch eine matrixartige Anordnung einzelner Speicherelemente 22 veranschaulicht. Jedes dargestellte Speicherelement 22 kann 1 Byte speichern. Jede Zeile der dargestellten Matrix-Anordnung entspricht einer Seite des Flash-Speichers. Sie könnte beispielsweise 256 Byte umfassen, im dargestellten Beispiel sind zur besseren Übersicht nur 32 Byte dargestellt.

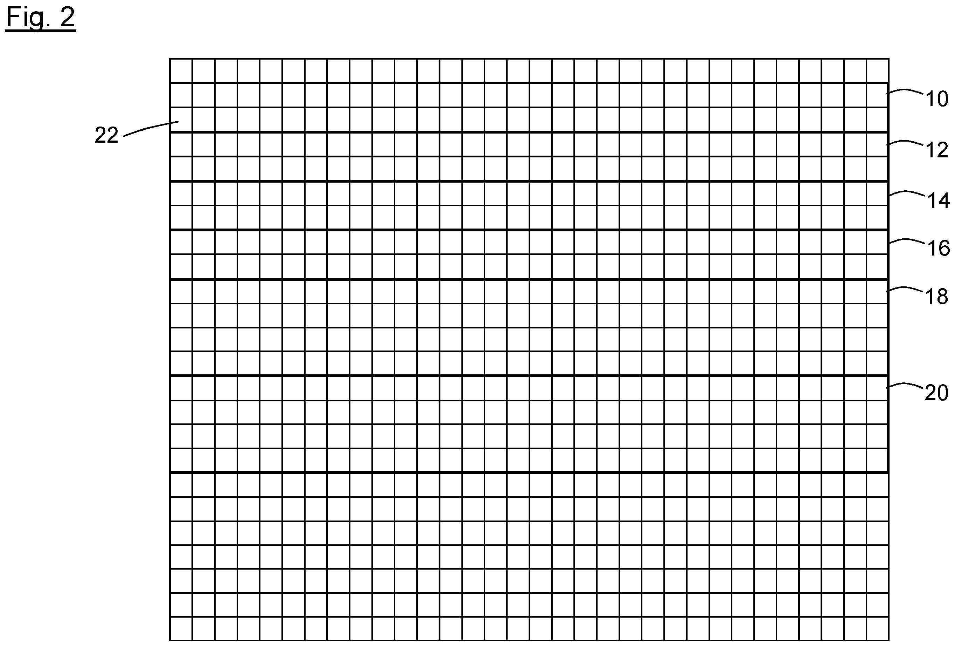

Figur 2 zeigt den Flash-Speicher aus Figur 1 nach der vorgesehenen Organisation in eine Anzahl N von Speicherbereichen, wobei nur sechs Speicherbereiche 10 bis 20 dargestellt sind. Jeder dieser Speicherbereiche ist durch einen den Speicherbereich umgebenden Rahmen gekennzeichnet. Die vier Speicherbereiche 10, 12, 14, 16 erstrecken sich jeweils über zwei Zeilen, d.h. über zwei Seiten des Flash-Speichers. Sie weisen jeweils ein Speichervolumen von 64 Byte auf. Die beiden Speicherbereiche 18, 20 erstrecken sich jeweils über vier Zeilen, d.h. über vier Seiten des Flash-Speichers, weisen demnach jeweils ein Speichervolumen von 128 Byte auf. Jeder der Speicherbereiche 10 bis 20 beginnt an einer definierten Startadresse, die auf das erste Speicherelement 22 des jeweiligen Speicherbereichs zeigt.

Zudem ist jeder der Speicherbereiche 10 bis 20 einem bestimmten Kanal zugeordnet. Diese Kanäle können sich hinsichtlich der Art und Größe der Messwerte, die zu den jeweiligen Kanälen erfasst werden unterscheiden. Im dargestellten Beispiel sind die Speicherbereiche 10 bis 16 zur Aufnahme von Messwerten vorgesehen, die jeweils 1 Byte groß sind. Die Speicherbereiche 18 und 20 sind für Messwerte vorgesehen, die jeweils 2 Bytes groß sind.

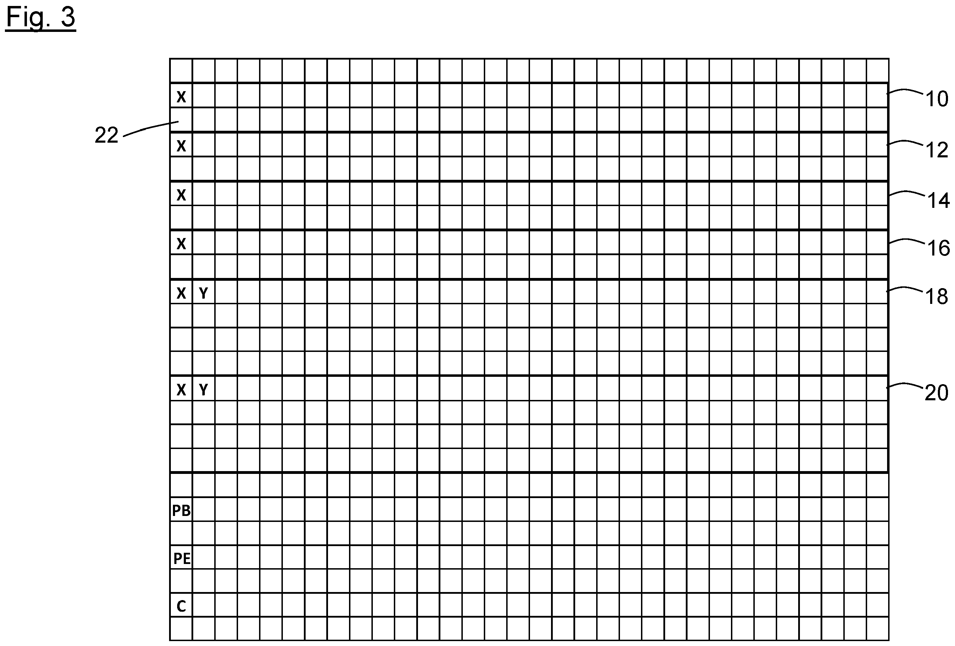

Bei dem Verfahren werden fortlaufend Messwerte für alle Kanäle erfasst bzw. berechnet, und zwar für jeden Kanal in jeder Periode ein Messwert. Nach der ersten Periode werden die in dieser Periode erfassten Daten in dem Flash-Speicher gespeichert. Anschließend ergibt sich das in Fig. 3 dargestellte Bild, bei dem in jedem der Speicherbereiche 10 bis 20 das an der jeweiligen Startadresse stehende Feld mit einer Größe von 1 Byte bei den vier Speicherbereichen 10 bis 16 und mit einer Größe von 2 Bytes bei den beiden Speicherbereichen 18 und 20 gefüllt ist. Die Messwerte der zu den Speicherbereichen 10 bis 16 gehörenden Kanäle sind jeweils durch ein X dargestellt, die Messwerte für die den Speicherbereichen 18 und 20 zugeordneten Kanäle jeweils durch ein XY. Alle Messwerte sind fett dargestellt, weil sie in der aktuellen Periode geschrieben worden sind.

Unterhalb der Speicherbereiche 10 bis 20 wurden weitere Daten in den Flash-Speicher geschrieben. Dabei handelt es sich um einen ersten Zeitstempel PB, der den Beginn der ersten Periode beschreibt, und einen zweiten Zeitstempel PE, der das Ende der ersten Periode beschreibt. Außerdem wurde eine Perioden-Prüfsumme C berechnet und ebenfalls in dem Flash-Speicher gespeichert. Die Bereiche des Flash-Speichers, in denen die Zeitstempel und die Perioden-Prüfsummen gespeichert werden, befinden sich an anderer Stelle als die N Speicherbereiche. Beispielsweise können sie in einem den N Speicherbereichen vorangestellten Abschnitt des Flash-Speichers, oder, wie dargestellt, in einem sonstigen Bereich des Flash-Speichers angeordnet sein.

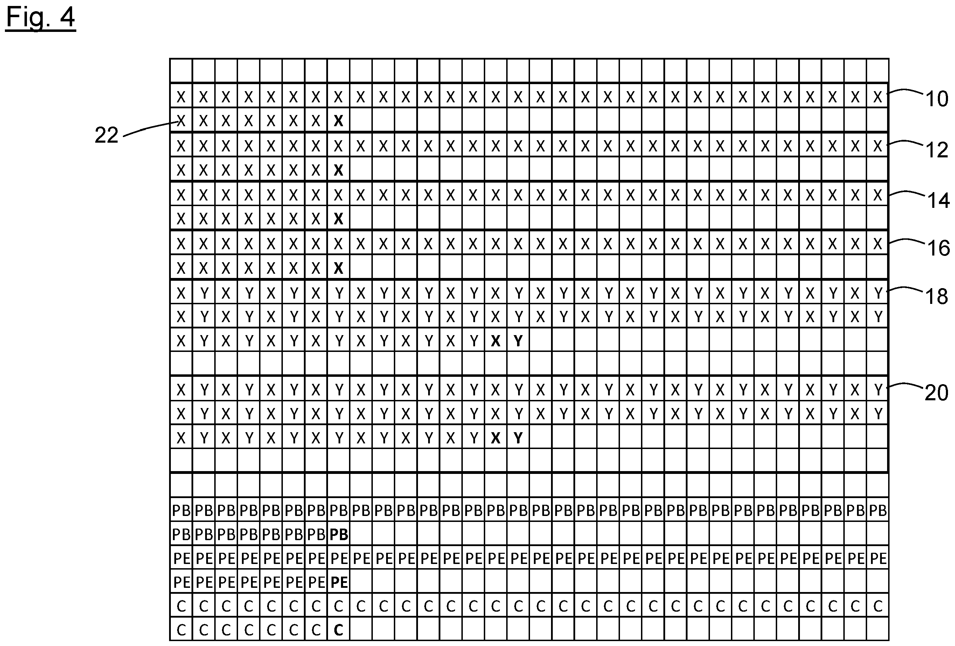

Nach einer Vielzahl weiterer Perioden, in denen kontinuierlich Messwerte erfasst und in dem Flash-Speicher gespeichert worden sind, ergibt sich das in der Fig. 4 dargestellte Bild. Man erkennt, dass die Speicherbereiche 10 bis 20 jeweils zu einem Großteil mit Messwerten gefüllt sind, wobei zuletzt die jeweils fett dargestellten Messwerte geschrieben worden sind.

Auch die Speicherbereiche für die ersten und zweiten Zeitstempel sowie für die Perioden-Prüfsummen sind bereits weitgehend gefüllt.

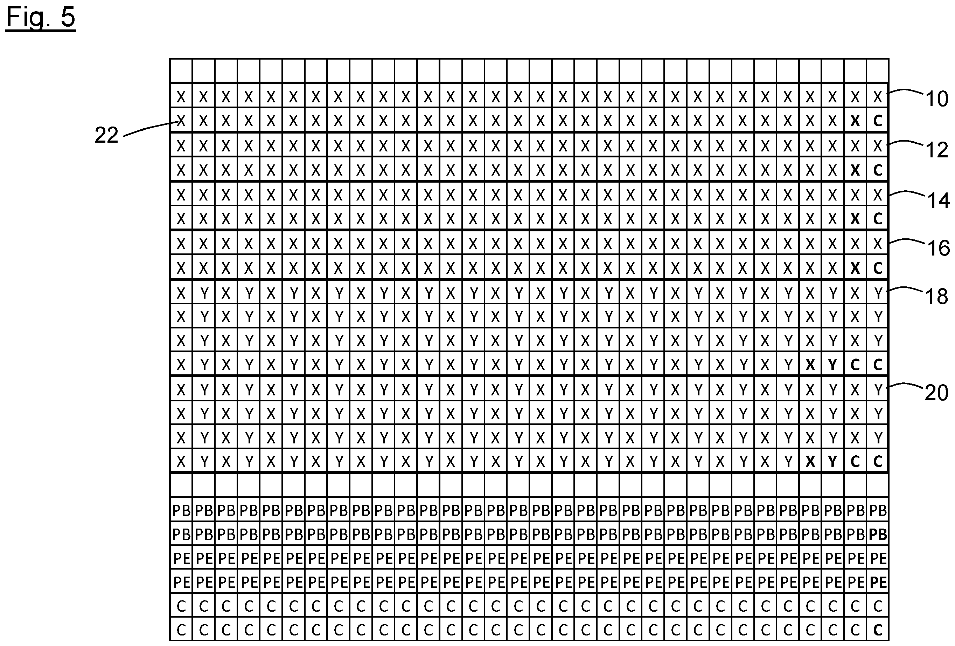

Nach dem Abschluss der P-ten Periode, dargestellt in Fig 5, sind alle Speicherbereiche 10 bis 20 gefüllt. In der letzten, P-ten Periode wurde dabei jeweils in jeden der Speicherbereiche 10 bis 20 ein weiterer Messwert X bzw. XY geschrieben, wiederum fett dargestellt. Außerdem wurde in jeden der Speicherbereiche 10 bis 20 eine Kanal-Prüfsumme C bzw. CC gespeichert. Diese Kanal-Prüfsummen befinden sich jeweils am Ende des jeweiligen Speicherbereichs 10 bis 20. die Prüfsummen C und CC wurden während des periodischen Erfassens und Speicherns der PQ-Daten kontinuierlich in einem Arbeitsspeicher, der in den Figuren nicht dargestellt ist, vorgehalten und in der P-ten Periode bzw. unmittelbar im Anschluss an diese Periode in der in Fig, 5 dargestellten Weise in dem Flash-Speicher gespeichert.

Aus Gründen der Übersichtlichkeit wurde hier angenommen, dass die Platzierung der P Datenwerte und der Prüfsumme eines Kanals jeweils in einer "naheliegenden" Reihenfolge erfolgt. Zuerst die Daten von vorne nach hinten, danach die zugeordnete Prüfsumme. Es ist offensichtlich, dass diese Platzierung auf vielfältige Weise variiert werden kann, ohne den Gedanken der Erfindung zu ändern. Beispielsweise könnte die Checksumme zu Beginn oder in der Mitte zwischen den P Datenwerten platziert werden. Auch könnten die P Datenwerte von hinten nach vorne angeordnet werden. Auch wenig sinnvolle Varianten, wie eine nach festem Schema verwürfelte Platzierung der P Datenwerte würde ggf. nur zur unerheblichen Einbußen der Leistungsfähigkeit führen und könnte als mögliche Variation der Erfindung in Betracht gezogen werden.

## Patentansprüche

1. Verfahren zum Speichern von PQ-Daten in einem Flash-Speicher, mit den folgenden Schritten:
• Bereitstellen eines Flash-Speichers,
• Periodisches Erfassen von PQ-Daten mit einer Anzahl N von Kanälen, wobei in zeitlich aufeinanderfolgenden Perioden für jeden der N Kanäle ein Messwert (X, XY) anfällt, und
• Periodisches Speichern der Daten in dem Flash-Speicher, **gekennzeichnet durch** den Schritt:
• Organisieren des Flash-Speichers in eine Anzahl N von Speicherbereichen (10 bis 20) für den ersten bis N-ten Kanal, wobei jeder der Speicherbereiche (10 bis 20) eine Startadresse und ein fortlaufendes, an der Startadresse beginnendes Speichervolumen aufweist, und **dadurch, dass**
• beim periodischen Speichern der Daten in einer ersten Periode für jeden Kanal ein erster Messwert (X, XY) an einer ersten Position des zugehörigen Speicherbereichs (10 bis 20) gespeichert wird und in jeder weiteren Periode für jeden Kanal ein weiterer Messwert (X, XY) in dem zugehörigen Speicherbereich (10 bis 20) gespeichert wird, und zwar an einer sich an den in der vorherigen Periode in diesem Speicherbereich (10 bis 20) gespeicherten Messwert (X, XY) anschließenden Position.

2. Verfahren nach Anspruch 1, **dadurch gekennzeichnet, dass** die Daten jeweils einer Periode in einem Pufferspeicher gespeichert und anschließend von dem Pufferspeicher in den Flash-Speicher kopiert werden.

3. Verfahren nach Anspruch 2, **dadurch gekennzeichnet, dass** der Pufferspeicher in Form einer Queue realisiert ist, wobei jedes Element der Queue einen Schreibauftrag darstellt, der ein Datenfeld mit den zu schreibenden Daten aufweist sowie ein Adressfeld mit der Angabe, an welchem Ort im Flash zu speichern ist.

4. Verfahren nach einem der Ansprüche 1 bis 3, **dadurch gekennzeichnet, dass** das Verfahren für eine vorgegebene Anzahl P von Perioden ausgeführt wird, wobei die N Speicherbereiche (10 bis 20) jeweils ein Speichervolumen aufweisen, das zum Speichern von P Messwerten des zugehörigen Kanals ausreicht.

5. Verfahren nach einem der Ansprüche 1 bis 4, **dadurch gekennzeichnet, dass** für jeden Kanal fortlaufend eine Kanal-Prüfsumme (C) berechnet und in einem Arbeitsspeicher gespeichert wird.

6. Verfahren nach Anspruch 5, **dadurch gekennzeichnet, dass** nach dem Erfassen der Daten der P-ten Periode die Kanal-Prüfsumme (C) jedes Kanals in dem Flash-Speicher gespeichert wird.

7. Verfahren nach einem der Ansprüche 1 bis 6, **dadurch gekennzeichnet, dass** die N Speicherbereiche (10 bis 20) jeweils ein Speichervolumen aufweisen, das der Größe von P Messwerten des zugehörigen Kanals zuzüglich der Größe einer Prüfsumme (C, CC) entspricht, wobei die Kanal-Prüfsumme (C, CC) jedes Kanals in dem zugehörigen Speicherbereich (10 bis 20) gespeichert wird.

8. Verfahren nach einem der Ansprüche 1 bis 7, **dadurch gekennzeichnet, dass** für jede Periode eine Perioden-Prüfsumme (C) berechnet und in dem Flash-Speicher gespeichert wird.

9. Verfahren nach einem der Ansprüche 5 bis 8, **dadurch gekennzeichnet, dass** die Kanal-Prüfsummen (C, CC) und/oder die Perioden-Prüfsummen (C) CRC-Werte sind.

10. Verfahren nach einem der Ansprüche 1 bis 9, **dadurch gekennzeichnet, dass** beim Speichern der Daten einer Periode ein erster Zeitstempel (PB) für den Beginn der Periode und ein zweiter Zeitstempel (PE) für das Ende der Periode in dem Flash-Speicher gespeichert werden.

11. Verfahren nach einem der Ansprüche 1 bis 10, **dadurch gekennzeichnet, dass** das Speichern der Daten der ersten Periode in einem zuvor gelöschten Speichersegment erfolgt, dessen Größe zur Aufnahme aller Daten bis zur P-ten Periode ausreicht.

12. Verfahren nach einem der Ansprüche 1 bis 11, **dadurch gekennzeichnet, dass** zur Weiterverarbeitung der in dem Flash-Speicher gespeicherten Daten die Messwerte (X, XY) eines einzigen Kanals oder ausschließlich eines Teils der Kanäle für eine Vielzahl von Perioden ausgelesen werden.

13. Verfahren nach einem der Ansprüche 1 bis 12, **dadurch gekennzeichnet, dass** zur Weiterverarbeitung der in dem Flash-Speicher gespeicherten Daten die Daten ausgelesen und in Form einer PQDIF-Datei bereitgestellt werden.

14. Verfahren nach einem der Ansprüche 1 bis 13, **dadurch gekennzeichnet, dass** das Verfahren von einem Elektrizitätszähler, der eine Messeinrichtung zum Erfassen der Daten und den Flash-Speicher aufweist, ausgeführt wird.

15. Verfahren nach einem der Ansprüche 1 bis 14, **dadurch gekennzeichnet, dass** der Elektrizitätszähler einen Kondensator oder eine Batterie aufweist und im Falle eines Netzausfalls das Speichern bereits erfasster Daten in dem Flash-Speicher mittels Energieversorgung aus dem Kondensator bzw. aus der Batterie abgeschlossen wird.

16. Elektrizitätszähler mit einer Messeinrichtung zum Erfassen von PQ-Daten und einem Flash-Speicher, **dadurch gekennzeichnet, dass** der Elektrizitätszähler eine Steuerung aufweist, die dazu ausgebildet ist, ein Verfahren mit den Merkmalen eines der Ansprüche 1 bis 15 auszuführen.
